Europäisches Patentamt

European Patent Office

Office européen des brevets

(11) Publication number: **0 345 494**
**A2**

## EUROPEAN PATENT APPLICATION

(21) Application number: **89108862.7**

(22) Date of filing: **17.05.89**

(51) Int. Cl.4: **G11C 7/00**

(30) Priority: **07.06.88 US 203495**

(43) Date of publication of application:
**13.12.89 Bulletin 89/50**

(84) Designated Contracting States:
**DE FR GB SE**

(71) Applicant: **THE BOEING COMPANY**
**20403 68th Avenue**
**South Kent Washington 98032(US)**

(72) Inventor: **Falk, Aaron R.**
**15509 S.E. 184**
**Renton Washington 98058(US)**

(74) Representative: **Strehl, Schübel-Hopf,**
**Groening, Schulz**
**Maximilianstrasse 54 Postfach 22 14 55**
**D-8000 München 22(DE)**

(54) **Opto-electronic memory device.**

(57) A fully optical random access memory device is
disclosed having an opto-electronic substrate. A
write beam, having a wavelength within the absorption band of the opto-electronic substrate, and a read
beam, having a wavelength outside the absorption
band of the opto-electronic substrate, are used to
read and write information to the fully optical random
access memory (26). The noninvasive optical read-
ing of information provides a device capable of sub-
nanosecond access times.

*FIG. 4*

## OPTO-ELECTRONIC MEMORY DEVICE

### Background of the Invention

The invention is related to random access memory devices. In particular, the invention is related to a fully optical random access memory.

One of the major speed limitations in electronic digital devices is the time delay caused by the RC time constants of the interconnecting lines. The time delay problem is especially acute in electronic memory devices and has typically limited device access times in the multi-nanosecond range.

Hybrid memory devices have been developed that combine optical write access and electronic read access to improve overall device access time. For example, U.S. Patent 3,686,645 discloses a charge storage flip-flop in which a laser source generates a photocharge that is stored in photosensitive transistors. The stored photocharge, however, must be read from the device by conventional electronic techniques. While hybrid devices offer some improvement over electronic memory devices, a fully optical technique for reading and writing could yield an optical random access memory (RAM) with a potential for sub-nanosecond access times.

### Summary of the Invention

An object of the present invention is to provide a fully optical random access memory device. Recently, noninvasive optical techniques have been developed for probing integrated circuit devices. These techniques are based on the phenomenon that if semiconductor material (for example Gabs and Si) is probed by an optical probe beam having a wavelength outside the absorption band of the material, any charge density present in the area probed will cause a change in the phase and/or polarization of the probe beam. (See, for example, J. L. Freeman et al Appl. Phys. Lett. 47, 1083 (1985), B. H. Kolner et al, "Electro-optic Sampling in Gabs Integrated Circuits", IEEE Journal of Quantum Electronics, Vol. QE-22, 79 No. 1, January 1986 and H. K. Heinrich et al, "Noninvasive Sheet Charge Density Probe for Integrated Silicon Devices", Applied Physics Letter 48(16), pp 1066-1068, April 21, 1986.) The change in the probe beam can be detected and used to determine if a charge is present. In accordance with the principles of the invention, the change in the probe beam can be used to determine if an electronic device, such as a FET, is on or off.

The present invention combines noninvasive optical techniques with techniques of injecting charges into an opto-electronic material by probing the material with an optical beam whose wavelength is within the material's absorption band. The combined techniques produce an optical memory element. Arrays of the optical memory elements may then be formed to provide a fully optical random access memory.

More particularly, the present invention provides an optical random access memory having a plurality of optical memory elements formed in an optoelectronic substrate, means for selectively applying a write beam to said plurality of optical memory elements, said write beam having a wavelength within the absorption band of said opto-electronic substrate, means for selectively applying a read beam to said plurality of optical memory elements, said read beam having a wavelength outside the absorption band of said opto-electronic substrate, and means for detecting at least one of a phase or polarization change in the read beam when the read beam is reflected back from the plurality of optical memory elements.

### Brief Description of the Drawings

With the above as background, reference should now be made to the following drawings in connection with the detailed description of the preferred embodiments in which:

Fig. 1 is a diagram of an optical memory element according to a first embodiment of the invention;

Fig. 2 is a diagram of an optical memory element according to a second embodiment of the invention;

Fig. 3 is an illustration of a Photo-FET that my be employed in the embodiment shown in Fig.2;

Fig. 4 is a block diagram of a system for scanning a optical memory device incorporating the optical memory elements shown in Figs. 1 and 2 with a read and write beam; and

Fig. 5 is a block diagram of a detector unit employed in the system shown in Fig. 4.

Fig. 6 is an illustration of a system according to the present invention employing parallel addressing.

### Detailed Description of the Preferred Embodiments

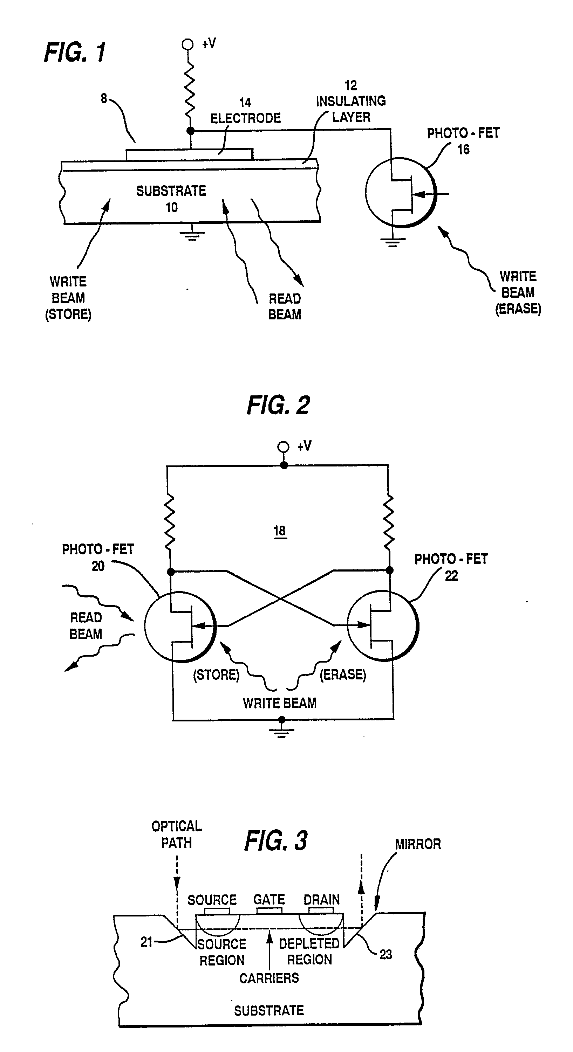

Referring now to Fig. 1, a first embodiment of an optical memory element according to the present invention is shown having a capacitive element 8 having an opto-electronic substrate 10, an insulating layer 12 and an electrode 14 formed on the insulating layer. A Photo-FET 16 is connected in parallel to the capacitive element 8. When a positive voltage is applied to the electrode 14 any electrons generated in the area of the electrode will be attracted to and stored in the capacitive element 8. This technique is similar to those used in charge coupled devices (CCDs). Photocharge (electrons) is generated and stored in the capacitive element 8 by a write beam having a wavelength within the absorption band of the opto-electronic substrate 10. The presence of the photocharge is then determined by changes in the phase and/or polarization of a read beam which is reflected off the electrode 14. The read beam has a wavelength outside the absorption band of the opto-electronic substrate 10. In order to erase the charge stored in the capacitive element 8, the Photo-FET 16 is turned on optically (using the write beam) thereby shorting out the bias voltage applied to the electrode 14 of the capacitive element 8.

The embodiment shown in Fig. 1 requires as little as one pico-joule of light energy to activate the memory element and also requires an occasional refresh due to recombination effects. A second embodiment that requires less optical power, as well as no refresh, is shown in Fig. 2. The second embodiment, however, requires a constant DC current flow.

Referring now to Fig. 2, the second embodiment of an optical memory element according to the present invention is shown consisting of an optical flip-flop 18 having two Photo-FETs 20-22 arranged to be optically switched between states. One, or possible both, of the Photo FETs 20-22 are probed by a read beam to determine if charge is flowing through the device. For example, in order to "store" a logic "1", a write beam activates Photo-FET 20 causing current to flow through that Photo-FET. Changes to the phase and/or polarization of the reflected read beam are then used to determine that Photo-FET 20 is "on" thereby indicating a "I" has been stored. In order to erase the "I" from memory (Photo-FET 20), the write light is directed to Photo-FET 22 causing Photo-FET 20 to be switched "off". Although the embodiment shown in Fig. 2 requires electronic interconnects between the Photo-FETs 20-22, the interconnects can be made short enough (on the order of a few microns) so as not to effect the overall device access time to a significant degree.

A conventional Photo-FET device may be employed for the "storing" Photo-FET 20. The charge carriers in · FET devices propagate parallel to the surface of the device in a very thin layer. The read beam, however, enters the substrate of the device to be scanned at an angle that is substantially perpendicular to the substrate. Thus, the read beam passes through the smallest dimension of the charge carrying region of a conventional Photo-FET limiting the interaction between the read beam and the charge carriers.

Optical interaction between the read beam and charge carriers, however, can be increased by utilizing the Photo-FET illustrated in Fig. 3 as the Photo-FET 20. Conventional ion milling or etching techniques are employed to form mirrors 21 and 23 in the substrate of the Photo-FET so that the optical path of the read beam is parallel to that of the charge carriers. The interaction length of the device shown in Fig. 3, therefore, is effectively extended over a conventional Photo-FET in which the read beam would enter the substrate perpendicular to the path of the charge carriers.

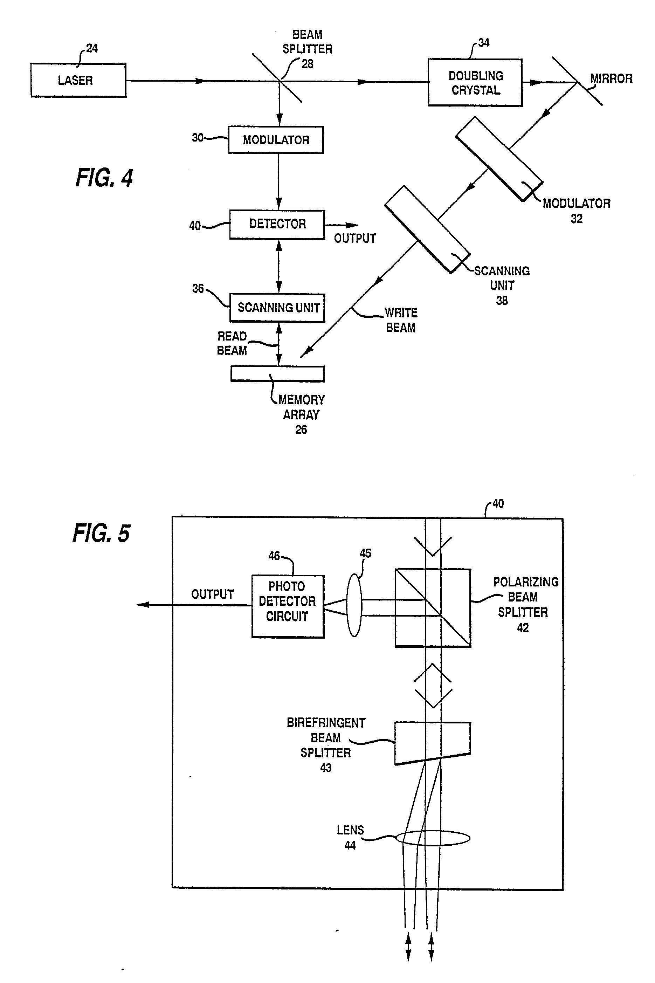

A memory array consisting of a plurality of the elemental memory devices illustrated in Figs. 1 and 2 can be formed using conventional solid state device fabrication techniques to form a fully optical random access memory. As shown in Fig. 4, a single yttrium aluminum garnet (YAG) laser 24 is utilized to provide both the read light and the write light used to address a fully optical random access memory 26 made in Gabs. A beam splitter 28 splits the beam from the laser 24 into a read beam and a write beam which are supplied to modulators 30 and 32, respectively. The modulators 30 and 32 selectively block the read and write beams to effect "on-off" control of the beams. The frequency of the write beam, however, is first doubled by a doubling crystal 34 before being provided to the modulator 32. The wavelength of the write beam is preferably about 532nm and the wavelength of the read beam is preferably about 1064nm. Scanning units 36 and 38 then independently scan the modulated read and write beams across the memory array to selectively address the elemental memory devices for reading and writing, respectively.

A detector unit 40 analyzes phase and/or polarization changes in the reflected read beam in order to determine the charge density present in the area probed by the read beam. The detector 40 detects the index of refraction change resulting from charge modulation or through the electro-optic effect by employing a high resolution interferometer, noninvasive technique, such as disclosed in the above referenced paper by Heinrich et al entitled, "Noninvasive Sheet Charge Density Probe for Integrated Silicon Devices" the contents of which are incorporated herein by reference. Detector 40 is illustrated in Figure #. The read beam from modulator 30 is passed through a polarizing beam splitter 42 and then through a birefringent beam splitter 43 which produces two beams of orthogonal polarization. An objective lens 44 focuses the two beams, which are deflected by the scanner unit 36, onto the memory array 26. One beam passes through the active area of the memory array to be probed while the second beam is reflected from a metalized area of the memory array 26 serving as a reference point. By placing the birefringent beam splitter 43 and the memory array 26 at the back and front focal planes of the objective lens 44, the two beams are reflected back along the same optical path and are recombined into a single beam by the birefringent beam splitter 43. The polarizing beam splitter 42 and a lens 45 direct the reflected light to a photodetector circuit 46 which produces an intensity modulated interference product. The output of the photodetector circuit 46 provides an intensity modulated electrical signal which is linear with respect to charge density.

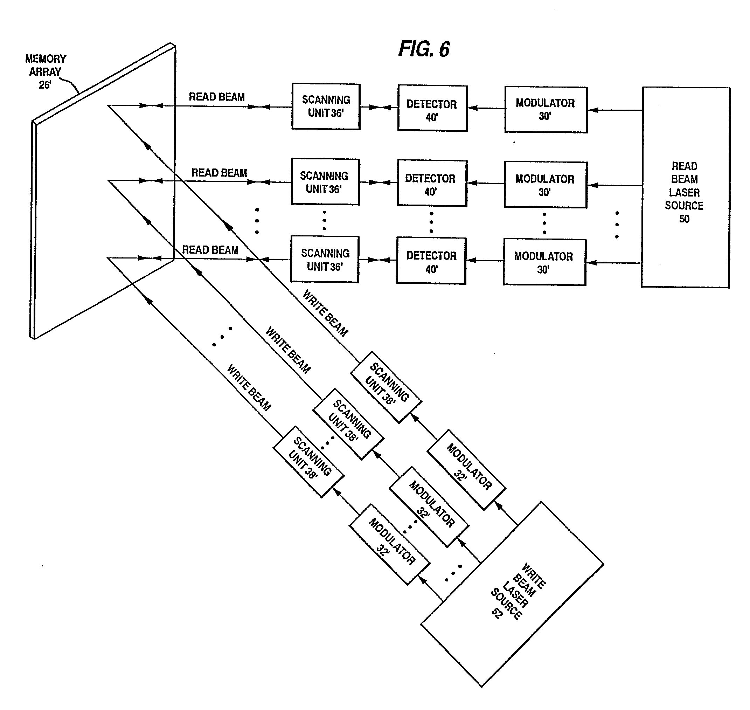

The embodiment of the invention illustrated in Fig. 4 represents a single channel system that addresses a single elemental memory device at a time. Parallel addressing schemes, however, employing a plurality of read and write channels, are also possible as illustrated in Fig. 6. A read beam laser source 50 generates a plurality of read beams, each read beam being supplied to a read channel having a modulator 30′ a detector 40′ and a scanning unit 36′. A write beam laser source 52 is provided to generate a plurality of write beams, each write beam being supplied to a write channel having a modulator 32′ and a scanning unit 38′. The corresponding read and write channels are arranged in parallel to simultaneously read and write to a group of elemental memory devices in the memory array 26′. Thus, parallel access to entire memory words or groups of words is possible.

In this embodiment, the read and write beam laser sources 50 and 52 utilize two separate lasers, having the aforementioned wavelength characteristics, with associated optics to generate the read and write beams. Optical arrangements utilizing a single laser and double crystal for corresponding read and write channels, however, may also be employed as shown in Fig. 4.

The invention has been described with reference to certain preferred embodiments thereof. It will be understood, however, that variations and modifications may be made within the spirit and scope of the invention.

## Claims

1. An optical random access memory comprising:

   a. a plurality of optical memory elements (26) formed in an opto-electronic substrate (10),

   b. means (24, 34, 32, 38) for selectively applying a write beam to said plurality of optical memory elements (26), said write beam having a wavelength within the absorption band of said opto-electronic substrate (10),

   c. means (24, 30, 36) for selectively applying a read beam to said plurality of optical memory elements (26), said read beam having a wavelength outside the absorption band of said opto-electronic substrate (10), and

   d. means (40) for detecting at least one of a phase and polarization change in the read beam when the read beam is reflected back from the plurality of optical memory elements (26).

2. An opto-electronic memory device comprising:

   a. an optical memory element (26) formed in an opto-electronic substrate (10),

   b. means (24, 34, 32, 38) for applying a write beam to said optical memory element (26), said write beam having a wavelength within the absorption band of said opto-electronic substrate (10),

   c. means (24, 30, 36) for applying a read beam to said optical memory element (26), said read beam having a wavelength outside the absorption band of said optoelectronic substrate (10), and

   d. means (40) for detecting at least one of a phase and polarization change in said read beam when said read beam is reflected back from said optical memory element (26).

3. An opto-electronic memory device comprising:

   a. an optical memory array (26′) having a plurality of optical memory elements formed in an optoelectronic substrate (10),

   b. means (52, 32′, 38′) for selectively applying a plurality of write beams to said optical memory elements (26′), said write beams having a wavelength within the absorption band of said opto-electronic substrate (10),

   c. means (50, 30′, 36) for selectively applying a plurality of read beams to said memory elements (26′), said read beams having a wavelength outside the absorption band of said opto-electronic substrate (10), and

d. means (40´) for detecting at least one of a phase and polarization change in said read beams when said read beams are reflected back from said optical memory elements (26´).

4. The device of any one of claims 1 to 3, wherein said optical memory elements (26) comprise a photo-electric capaci tor (8) having an insulating layer (12) formed over said opto-electronic substrate (10), an electrode (14) formed on said insulating layer (12) and means for applying a bias voltage to said electrode (14).

5. The device of claim 4, wherein said optical memory elements (26) further comprise a photo-FET (16) connected in parallel to said capacitor (8).

6. The device of any one of claims 1 to 3, wherein said optical memory elements (26) comprise first and second photo-FETs (20, 22) formed in said opto-electronic substrate (10), said first and second photo-FETs (20, 22) being connected to form a flip-flop circuit (18).

7. The device of claim 6, wherein said write beam selectively turns said first and second photo-FETs (20, 22) "ON" and said read beam probes said first photo-FET (20).

8. A method of operating an optical random access memory having a plurality of optical memory elements (26) formed from an opto-electronic substrate (10), said method comprising the steps of:

a. selectively scanning said plurality of optical memory elements (26) with a write beam having a wavelength within the absorption band of said opto-electronic substrate (10),

b. selectively scanning said plurality of optical memory elements (26) with a read beam having a wavelength outside the absorption band of said opto-electronic substrate (10), and

c. detecting at least one of a phase and polarization change in sad read beam when said read beam is reflected back from said plurality of opto-electronic memory elements (26).

9. A method of operating an opto-electronic memory device having an optical memory element (26) formed from an opto-electronic substrate (10), said method comprising the steps of:

a. writing in said optical memory element (26) by illuminating said optical memory element with a write beam having a wavelength within the absorption band of said opto-electronic substrate (10),

b. reading said optical memory element (26) by illuminating said optical memory element with a read beam having a wavelength outside the absorption band of said opto-electronic substrate (10), and

c. detecting at least one of a phase and polarization change in said read beam when said read beam is reflected back from said optical memory element (26).

**FIG. 1**

**FIG. 2**

**FIG. 3**

## FIG. 4

BEAM
SPLITTER
28

LASER 24

DOUBLING
CRYSTAL 34

MIRROR

MODULATOR 30

MODULATOR
32

DETECTOR 40

OUTPUT

SCANNING
UNIT
38

SCANNING UNIT 36

WRITE
BEAM

READ
BEAM

MEMORY
ARRAY
26

## FIG. 5

40

OUTPUT

PHOTO
DETECTOR
CIRCUIT 46

45

POLARIZING
BEAM
SPLITTER
42

BIREFRINGENT
BEAM
SPLITTER
43

LENS
44

# FIG. 6

MEMORY ARRAY 26'

READ BEAM → SCANNING UNIT 36' → DETECTOR 40' → MODULATOR 30'

READ BEAM → SCANNING UNIT 36' → DETECTOR 40' → MODULATOR 30'

READ BEAM → SCANNING UNIT 36' → DETECTOR 40' → MODULATOR 30'

READ BEAM LASER SOURCE 50

WRITE BEAM → SCANNING UNIT 38' → MODULATOR 32'

WRITE BEAM → SCANNING UNIT 38' → MODULATOR 32'

WRITE BEAM → SCANNING UNIT 38' → MODULATOR 32'

WRITE BEAM LASER SOURCE 52

EP 0 345 494 A2